# EUROPÄISCHE PATENTSCHRIFT

(11) **EP 3 526 812 B1**
(45) Veröffentlichungstag und Bekanntmachung des Hinweises auf die Patenterteilung: **29.07.2020**
(21) Anmeldenummer: 17784936.1
(22) Anmeldetag: 16.10.2017
(51) Int. Cl.: H01L 21/3065, B81C 1/00, H01J 37/32

(54) **VERFAHREN ZUM ANISOTROPEN DRIE-ÄTZEN MIT FLUORGASMISCHUNG**
METHOD FOR ANISOTROPIC DEEP REACTIVE-ION ETCHING WITH A FLUORINE GAS MIXTURE
PROCÉDÉ DE GRAVURE IONIQUE RÉACTIVE PROFONDE ANISOTROPE FAISANT APPEL À UN MÉLANGE GAZEUX FLUORÉ

(30) Priorität: 17.10.2016 DE 102016220248
(43) Veröffentlichungstag der Anmeldung: 21.08.2019
(73) Patentinhaber: Fraunhofer-Gesellschaft zur Förderung der angewandten Forschung e.V., 80686 München (DE)
(72) Erfinder: WIELAND, Robert, 81686 München (DE)
(74) Vertreter: Hersina, Günter
(86) Internationale Anmeldenummer: PCT/EP2017/076265
(87) Internationale Veröffentlichungsnummer: WO 2018/073135

(56) Entgegenhaltungen:
- WO-A2-2009/080615
- US-A- 5 501 893
- KARL KUEHL ET AL: "Advanced silicon trench etching in MEMS applications", PROCEEDINGS OPTICAL DIAGNOSTICS OF LIVING CELLS II, Bd. 3511, 31. August 1998 (1998-08-31), Seiten 97-105, XP055441716, US ISSN: 0277-786X, DOI: 10.1117/12.324331 ISBN: 978-1-5106-1324-9
- GIRARD G ET AL: "Matrix-distributed ECR-PECVD for high-rate deposition of silica for applications in integrated optics", VISUAL COMMUNICATIONS AND IMAGE PROCESSING; 20-1-2004 - 20-1-2004; SAN JOSE,, Bd. 4944, 1. Januar 2003 (2003-01-01), Seiten 62-71, XP002436134, DOI: 10.1117/12.468294 ISBN: 978-1-62841-730-2

## Beschreibung

Die Erfindung betrifft ein Verfahren zum reaktiven Ionentiefenätzen unter Verwendung einer Fluorgasmischung mit den Merkmalen von Anspruch 1 sowie die Verwendung einer solchen Fluorgasmischung zum reaktiven Ionentiefenätzen mit den Merkmalen von Anspruch 10.

Zum Herstellen von Halbleiterbauelementen und MEMS (Micro Electro Mechanical Structures) Systemen werden Substrate strukturiert. Hierfür können unterschiedliche Ätzprozesse genutzt werden. Bekannt sind nasschemische und Trockenätzverfahren, wobei letztere nochmals in chemische und physikalische Prozesse unterschieden werden.

Bei den chemischen Trockenätzprozessen (engl. chemical dry etching, CDE) kommt es zu einer chemischen Reaktion zwischen den neutralen Teilchen/Molekülen (i.d.R. Radikale) und der Oberfläche des Substrats, wodurch das Substrat strukturiert wird. Die Radikale werden in einem Plasma erzeugt, weshalb der chemische Trockenätzprozess umgangssprachlich auch als Plasma-Ätzverfahren bezeichnet wird. Die chemischen Trockenätzprozesse zeigen in der Regel ein sehr isotropes Ätzverhalten.

Die physikalischen Trockenätzverfahren weisen hingegen ein eher anisotropes Ätzbild auf. Hier wird die Oberfläche des Substrates durch den Beschuss von Ionen, Elektronen oder auch Photonen geätzt. Die dabei ablaufenden Prozesse zum Strukturieren des Substrats sind den beim Sputtern ablaufenden Prozessen ähnlich. Physikalische Trockenätzverfahren haben jedoch meist eine relativ niedrige Ätzrate, die zudem nur eine geringe Materialselektivität aufweist. Durch das damit verbundene Ätzen der Maske ergeben sich Abrundungen an den Kanten. Des Weiteren sind für das Ätzen hohe Energien notwendig, so dass die Ionen auch tiefer in das Material eindringen. Es wird daher nicht nur oberflächlich geätzt, sondern auch tieferliegende Schichten werden beschädigt. Ein weiterer Nachteil sind parasitäre Abscheidungen (engl. redeposition) der geätzten Teilchen auf dem Substrat und der Maske bzw. den Maskenkanten.

Eine Mischform der beiden Trockenätzverfahren, die die Vorteile des chemischen und des physikalischen Trockenätzens miteinander vereint, ist das physikalisch-chemische Trockenätzverfahren (engl. physical-chemical dry etching), das umgangssprachlich auch als Plasma-unterstütztes Ätzen bezeichnet wird. Die Edukte werden meist über ein Plasma aktiviert oder radikalisiert und anschließend mittels Ionenbeschleunigung auf das Substrat geleitet. Bekannte Vertreter der physikalisch-chemischen Trockenätzverfahren sind das reaktive lonenätzen (engl. reactive ion etching, RIE) und das reaktive Ionentiefenätzen (engl. deep reactive ion etching, DRIE). Das reaktive Ionentiefenätzen (DRIE) ist auch unter dem Namen Bosch-Prozess bekannt.

Bekannte Ätzverfahren sind beispielsweise beschrieben in der WO 2009 / 080615 A2 sowie in KARL KUEHL ET AL.: "Advanced silicon trench etching in MEMS applications", PRO-CEEDINGS OF OPTICAL DIAGNOSTICS OF LIVING CELLS II, Bd. 3511, 31. August 1998 (1998-08-31), Seiten 97-105, XP055441716, US, ISBN: 978-1-5105-1324-9.

In all den oben genannten Ätzverfahren werden spezielle Gase oder Gasgemische als Ätzgas verwendet. Dabei sind die jeweiligen Ätzgase für das jeweilige Ätzverfahren spezifisch. Insbesondere bei Gasgemischen können bereits Abweichungen von 1% einer jeweiligen Gaskomponente dazu führen, dass das gewählte Ätzverfahren nicht mehr ausführbar ist.

Beispielsweise wird für das reaktive Ionentiefenätzen Schwefelhexafluorid SF₆ als Ätzgas eingesetzt, da SF₆ eine sehr gute und reproduzierbare Prozessführung erlaubt. Schwefelhexafluorid SF₆ ist außerdem einfach handhabbar und relativ ungefährlich.

Schwefelhexafluorid SF₆ ist allerdings ein äußerst umweltschädliches Gas mit einem GWP-Wert von > 22800 (GWP = Global Warming Potential) und trägt in hohem Maße zur globalen Erwärmung bei ("Klimakiller"). Des Weiteren kumulieren Ätzanlagen im Dauerbetrieb große Mengen teilreagierter Schwefelverbindungen in den Vakuum-Pumpleitungen der Reaktoren. Dies ist bei 24h-Betrieb nicht erwünscht und verursacht vergleichsweise hohe Wartungskosten.

Es ist eine Aufgabe der vorliegenden Erfindung, das reaktive lonentiefenätzen zum anisotropen Strukturieren von Substraten unter Beibehaltung der für dieses Verfahren charakteristischen Ätzeigenschaften umweltfreundlicher zu gestalten.

Diese Aufgabe wird erfindungsgemäß durch ein Ätzverfahren mit den Merkmalen von Anspruch 1 gelöst.

Das erfindungsgemäße Ätzverfahren beinhaltet ein anisotropes Strukturieren eines Siliziumsubstrats mittels reaktivem lonentiefenätzen (DRIE: deep reactive ion etching) mit mehreren abwechselnd aufeinander folgenden Ätzschritten und Passivierungsschritten. Erfindungsgemäß wird zum Ätzen eine Fluorgasmischung eingesetzt, die einen Anteil von mehr als 25% bis einschließlich 40% Fluor (25% < F₂ <= 40%), einen Anteil von 1% bis 50% Stickstoff (1% <= N₂ <= 50%) und einen Anteil von 30% bis einschließlich 60% eines Edelgases (30% <= Edelgas <= 60%) aufweist. Diese spezielle Zusammensetzung des erfindungsgemäßen Fluorgasgemisches eignet sich sehr gut, um das bisher verwendete SF₆ zu ersetzen. Die Erfindung basiert darauf, dass nach bisherigen Erkenntnissen F₂-Fluorgasmischungen ein sehr isotropes Ätzverhalten aufweisen, d.h. im Gegensatz zu fluorhaltigen Molekülen (z.B. CF₄, CHF₃, C₄F_{B} u.a.) sind F₂-Fluorgasmischungen nicht dafür geeignet, Feinstrukturierungen im Nanometerbereich, wie z.B. Halbleiterbauelemente, zu realisieren, da hierfür reines reaktives lonenätzen mit entsprechend hohen Selektivitäten zur Seitenwand (= sehr glatte Seitenfläche der erzeugten Strukturen) angewendet wird. Daher werden F₂-Fluorgasmischungen bisher nur z.B. zum Reinigen von CVD-Anlagen eingesetzt, wobei die CVD-Anlagen mit dem F₂-Fluorgasgemisch geflutet werden und hierbei ein isotropes Ätzverhalten gewünscht ist. Dahingegen benötigen fast alle konventionellen Plasmaanlagen, welche zur Feinstrukturierung von Halbleiter- oder MEMS-Bausteinen unter Verwendung von Fotolackmasken eingesetzt werden, immer eine entsprechende Selektivität zur Maske sowie eine fortlaufende Seitenwandpassivierung, um den unerwünschten "Undercut" (= Unterätzung der zu ätzenden Schicht) zu vermeiden. Dies gelingt in der Regel jedoch nur unter Verwendung von polymerisierenden Gasen wie z.B. CHF₃. Insofern können F₂-Gasmischungen hierfür nicht oder nur in sehr begrenztem Umfang verwendet werden, da F₂-Gasmischungen mit ihrer hohen Radikaldichte ohne zusätzliches Polymerisierungsgas nur isotrop ätzen, also einen Undercut erzeugen würden und somit nicht für ein anisotropes Ätzen in Frage kommen. Mit der erfindungsgemäßen Gaszusammensetzung ist es jedoch gelungen, F₂-Fluorgasmischungen entgegen bisheriger Annahmen zum anisotropen Strukturieren von Substraten einzusetzen.

Wie bereits eingangs erwähnt, können bei DRIE-Ätzverfahren bereits Abweichungen der Gaszusammensetzung in einem Bereich von lediglich 1% zu einer erheblichen Änderung der Ätzrate sowie der Durchführbarkeit des Verfahrens führen. Während der Durchführung eines Experiments ist man zu der überraschenden Erkenntnis gelangt, dass eine Fluorgasmischung mit einem Anteil von 35% bis einschließlich 40% Fluor, einem Anteil von 1% bis 50% Stickstoff und einem Anteil von 30% bis einschließlich 59% eines Edelgases deutlich bessere Ergebnisse hinsichtlich der Ätzrate und der Prozessführung geliefert hat, die die theoretischen Erwartungen dieser Zusammensetzung übertroffen hat.

Es ist denkbar, dass die Fluorgasmischung ein Edelgas aus der Gruppe von Argon, Neon, Krypton, Helium, Radon und Xenon aufweist.

Gemäß eines Ausführungsbeispiels kann die Fluorgasmischung Argon als einzige Edelgaskomponente aufweisen. Es hat sich gezeigt, dass die Verwendung Argon in Verbindung mit F₂ und N₂ besonders gute Ergebnisse beim Ätzen mittels des erfindungsgemäßen Verfahrens gebracht hat.

Ein weiteres Ausführungsbeispiel sieht vor, dass der Schritt des Passivierens das Aufbringen einer Passivierungsschicht auf das Substrat unter Verwendung von C₄F₆ als Prozessgas beinhaltet. Bisher wird bei bekannten DRIE-Prozessen zur Passivierung das Polymerisierungsgas C₄F₈ verwendet. Dieses Polymerisierungsgas C₄F₈ ist aber sehr umweltschädlich, d.h. es weist einen GWP-Index von 8700 auf (Global Warming Potential). Das Polymerisierungsgas C₄F₆ hingegen ist sehr viel umweltverträglicher, d.h. dieses Prozessgas weist einen GWP-Index von 1 auf. Die erfindungsgemäße Substitution von C₄F₈ durch C₄F₆ trägt also weiter dazu bei, die der Erfindung zugrunde liegende Aufgabe zu lösen, nämlich bisher bekannte DRIE-Prozesse deutlich umweltverträglicher zu gestalten.

Ausführungsbeispiele der Erfindung sehen unter anderem vor, dass das Verfahren das Erzeugen von reaktiven Ionen in einem Hochfrequenz-Direktplasma beinhaltet. Im Gegensatz zu einem sogenannten Remote-Plasma wird bei einem Direktplasma das Plasma direkt in der Ätzkammer erzeugt. Unter Hochfrequenz-Direktplasmen sind Plasmen zu verstehen, die mit einer Anregungsfrequenz von 3 MHz bis 300 GHz erzeugt werden.

Hierbei wäre es denkbar, dass das Verfahren das Erzeugen von reaktiven Ionen in einem induktiv oder kapazitiv eingekoppelten Hochfrequenz-Direktplasma mit einer Anregungsfrequenz im Kurzwellen-Frequenzband in einem Frequenzbereich von 3 MHz bis 30 MHz beinhaltet. Ein bevorzugter Hochfrequenzbereich erstreckt sich von 10 MHz bis 15 MHz. Eine ausgewählte Frequenz wäre beispielsweise 13,56 MHz.

Weitere Ausführungsbeispiele der Erfindung sehen vor, dass das Verfahren das Erzeugen von reaktiven Ionen in einem Hochfrequenzplasma mit einer Anregungsfrequenz im Mikrowellen-Frequenzband in einem Frequenzbereich von 0,3 GHz bis 3 GHz beinhaltet. Ein bevorzugter Hochfrequenzbereich erstreckt sich von 2 GHz bis 3 GHz. Eine ausgewählte Frequenz wäre beispielsweise 2,45 GHz. Mikrowellenanregung wird bei bekannten DRIE-Prozessen, die SF₆ als Ätzgas einsetzen, nicht angewandt, da Mikrowellenanregung, z.B. bei 2,5 GHz, für schwere Gase wie SF₆ ungeeignet ist, da die benötigte Hochfrequenzleistung zur Dissoziation von SF₆ in F-Radikale technisch nur extrem aufwendig oder nicht ausreichend hoch eingekoppelt werden kann. In Kombination mit der vorliegenden Erfindung, die die beanspruchte F₂-Fluorgasmischung als Ätzgas nutzt, ist die Anwendung von Mikrowellenanregung jedoch synergistisch sehr interessant. Fluor-Gasmischungen dissoziieren nämlich bereits bei einer im Vergleich dreifach geringeren Leistungsdichte in Fluor-Radikale und erlauben somit eine hohe Fluor-Radikaldichte auch mit Mikrowellenanregung. Mikrowellenplasmen erzeugen also sehr hohe Radikaldichten bei vergleichsweise niederem Energieeinsatz, was insbesondere bei Verwendung von Fluorgasmischungen zu einer erheblich höheren F-Radikaldichte führt.

Um mit Hilfe von Mikrowellenanregung eine ausreichend gute Ätzhomogenität über ein entsprechendes Siliziumsubstrat (Durchmesser 200 -300mm) erzielen zu können, ist ein weiteres Ausführungsbeispiel der Einsatz von mehreren, flächig regelmäßig angeordneten, einzeln angesteuerten Mikrowellen-Einkoppelquellen, welche mittels Höchstfrequenz-Leistungsansteuerung in der Lage sind, die Silizium- oder Maskenhomogenität der Abtragsrate zu optimieren.

Weitere Ausführungsbeispiele sehen vor, dass das erfindungsgemäße Verfahren das Erzeugen von reaktiven Fluor-Ionen und Fluor-Radikalen beinhaltet, wobei in einem ersten Zeitabschnitt mehr reaktive Fluor-Ionen als Fluor-Radikale erzeugt werden, und wobei in einem nachfolgenden zweiten Zeitabschnitt mehr Fluor-Radikale als reaktive Fluor-Ionen erzeugt werden. Die reaktiven Fluor-Ionen werden benötigt, um die Passivierungs- bzw. Polymerisierungsschicht aufzubrechen. Die Radikale wiederum ätzen mit hoher Selektivität das zu strukturierende Substrat. Daher sieht die Erfindung vor, zu Beginn eines Ätzschritts zuerst reaktive Fluor-Ionen zu erzeugen (z.B. für eine halbe Sekunde), die auf das Substrat geleitet werden, um die im vorangegangenen Passivierungsschritt aufgebrachte Passivierungsschicht zu durchbrechen. Darauffolgend werden dann Fluor-Radikale erzeugt und auf das freigelegte Substrat geleitet, um das Substrat zu ätzen bzw. zu strukturieren. Die Erzeugung von Radikalen und reaktiven Ionen in einem bestimmten Zeitfenster kann beispielsweise mittels einer mit der Plasmaquelle verbundenen Steuerung realisiert werden, die ausgebildet ist, um die Plasmaquelle entsprechend anzusteuern, sodass die Plasmaquelle zu unterschiedlichen Zeitpunkten unterschiedliche Verteilungen der Anteile an Fluor-Radikalen und Fluor-Ionen innerhalb des Plasmas produziert.

Ein weiterer Aspekt der Erfindung ist die Verwendung einer Fluorgasmischung zum anisotropen Strukturieren eines Siliziumsubstrats mittels reaktivem Ionentiefenätzen (DRIE: deep reactive ion etching) mit mehreren abwechselnd aufeinander folgenden Ätzschritten und Passivierungsschritten, wobei die Fluorgasmischung einen Anteil von mehr als 25% bis einschließlich 40% Fluor (25% < F₂ <= 40%), einen Anteil von 1% bis 50% Stickstoff (1% <= N₂ <= 50%) und einen Anteil von 30% bis einschließlich 60% eines Edelgases (30% <= Edelgas <= 60%) aufweist.

Zur Umsetzung der vorliegenden Erfindung kann beispielsweise eine Vorrichtung vorgesehen werden mit einem Reaktor zum anisotropen Strukturieren eines Siliziumsubstrats mittels reaktivem Ionentiefenätzen (DRIE: deep reactive ion etching) mit mehreren abwechselnd aufeinander folgenden Ätzschritten und Passivierungsschritten, und einer Gaszuführung zum Zuführen eines Ätzgases in den Reaktor, wobei eine Fluorgasmischung als Ätzgas eingesetzt wird, die einen Anteil von mehr als 25% bis einschließlich 40% Fluor (25% < F₂ <= 40%), einen Anteil von 1% bis 50% Stickstoff (1% <= N₂ <= 50%) und einen Anteil von 30% bis einschließlich 60% eines Edelgases (30% <= Edelgas <= 60%) aufweist.

Ausführungsbeispiele der Erfindung sind in der Zeichnung dargestellt und werden nachstehend erläutert. Es zeigen:
Fig. 1 eine schematische Schnittansicht eines mittels des erfindungsgemäßen Verfahrens strukturierten Siliziumsubstrats,
Fig. 2 eine konventionelle Plasmaanlage zum reaktiven lonentiefenätzen unter Verwendung von SF₆ als Prozessgas gemäß dem Stand der Technik, und
Fig. 3 eine beispielhafte Plasmaanlage, die zum erfindungsgemäßen reaktiven Ionentiefenätzen unter Verwendung der erfindungsgemäßen Fluorgasmischung als Prozessgas eingesetzt werden kann.

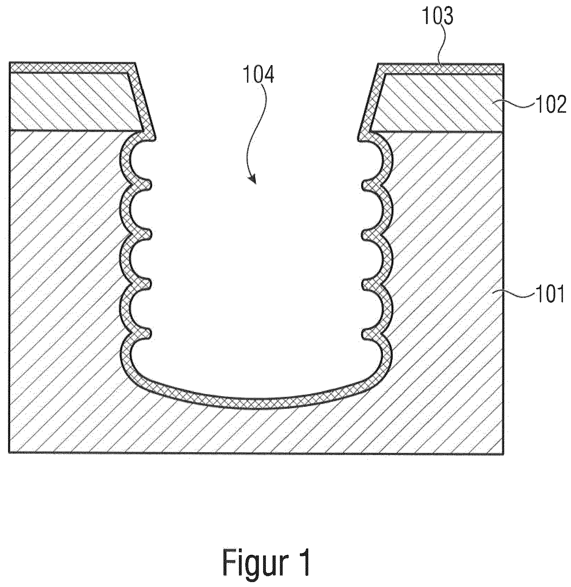

Figur 1 zeigt schematisch das Ätzbild eines Substrats 101, das unter Verwendung eines erfindungsgemäßen DRIE-Prozesses strukturiert wurde. Der DRIE-Prozess wird umgangssprachlich auch als Bosch-Prozess bezeichnet.

Die Besonderheit des Bosch-Prozesses besteht darin, dass regelmäßig zwischen isotroper Si-Ätzung und isotroper Polymerisation gewechselt wird und nur vergleichsweise wenig Anisotropie pro Si-Ätzschritt benötigt wird, vorrangig am Beginn jedes Si-Ätzschrittes. Obwohl die einzelnen Ätzschritte an sich isotrop sein können, weist die in dem Substrat 101 geätzte Struktur 104 aufgrund der abwechselnden Ätz- und Polymerisierungsschritte eine hohe Anisotropie auf.

Das in Figur 1 beispielhaft abgebildete Siliziumsubstrat 101 weist außerdem eine Passivierungsschicht (z.B. Oxid) 102 auf. Der zuvor erwähnte, sich wiederholende Passivierungsschritt führt außerdem dazu, dass sich eine weitere Passivierungsschicht bzw. eine Polymerschicht 103 auf dem Substrat 101 ablagert. Diese Polymerschicht 103 führt außerdem zu einer Boden- und Seitenwandpassivierung innerhalb der Kavität 104.

Der Bosch-Prozess beinhaltet eine abwechselnde und wiederkehrende Kombination von reaktiver Ionenätzung und Polymer-Deposition zur Erzeugung tiefer Gräben (Trenches), Kavitäten oder TSVs (Through Silicon Vias) 104 in Siliziumsubstraten 101. Bis dato wird bei Bosch-Prozessen nach dem Stand der Technik das Gas C₄F₈ zur Polymer-Deposition und das Ätzgas SF₆ zur eigentlichen Si-Ätzung verwendet.

Ein herkömmlicher Bosch-Prozess weist im Wesentlichen drei Prozessschritte auf:
a) Isotropes, chemisches Ätzen durch F-Radikale (gebildet aus SF₆)
b) Passivierung der Oberfläche durch C₄F₈ Gas, isotrop, keine Bias-RF
c) Entfernen der Bodenpassivierung durch beschleunigte Ionen (physikalisches Ätzen)

Die im Stand der Technik eingesetzten Ätzkammern verwenden allesamt eine sog. induktiv gekoppelte Plasmaanregung bei einer Frequenz von 13,56 MHz, gepaart mit einer gleichzeitig angelegten weiteren Plasmaquelle mit 13,56 MHz oder 400 kHz Frequenz, welche über die Kathode eine sogenannte DC-bias oder Beschleunigungsspannung erzeugt.

Das oben im Reaktor induktiv gekoppelte Plasma erzeugt eine relativ hohe Dichte an ungerichteten Fluor-Ionen und Fluor-Radikalen, welche zu 90% isotrop das Silizium ätzen, überwiegend auf Grund der hohen erzeugten Radikaldichte. Die überlagerte zweite Plasmaquelle beschleunigt SFₓ-Ionen senkrecht in Richtung Waferoberfläche und erzeugt damit den anisotropen Ätzanteil, welcher unabhängig von der induktiven Quelle geregelt wird.

Dieser anisotrope Ätzanteil wird nur zum Durchbrechen der zuvor abgeschiedenen, dünnen, teflonartigen Polymerschicht 102 am Boden des zu erzeugenden Grabens 104 benötigt (an den Seitenwänden des Grabens 104 bleibt das Polymer zum Schutz vor Unterätzung erhalten und erlaubt so die nächste isotrope Si-Ätzung mittels Fluor-Radikalen).

Die Polymerisierung erfolgt durch "Abscheiden" einer dünnen, PTFE-ähnlichen Schicht indem ein C₄F₈- Plasma gezündet wird, nur durch Anlegen der induktiv gekoppelten 13,56 MHz-Leistung, ohne Bias-RF.

Das bei herkömmlichen Bosch-Prozessen verwendete Ätzgas SF₆ ist ein äußerst umweltschädliches Gas mit einem GWP-Wert von >22800 (GWP = Global Warming Potential) und trägt in hohem Maße zur globalen Erwärmung bei ("Klimakiller"). Des Weiteren kumulieren im Dauerbetrieb o.g. Ätzanlagen große Mengen teilreagierter Schwefelverbindungen in den Vakuum-Pumpleitungen der Reaktoren. Dies ist bei 24h-Betrieb nicht erwünscht und verursacht vergleichsweise hohe Wartungskosten.

Die Erfindung sieht daher unter anderem vor, das bisher verwendete Ätzgas SF₆ im Bosch-prozess durch Fluorgasmischungen zu ersetzen, um lithographisch vorgegebene tiefe Strukturen 104 in einem Substrat (z.B. Bulk-Silizium) 101 erzeugen zu können mit Aspektverhältnissen weit über den Faktor 20:1 hinaus (Aspektverhältnis = Tiefe zu Grabenbreite).

Erfindungsgemäß beinhaltet die Fluorgasmischung einen Anteil von mehr als 25% bis einschließlich 40% Fluor (25% < F₂ <= 40%), einen Anteil von 1% bis 50% Stickstoff (1% <= N₂ <= 50%) und einen Anteil von 30% bis einschließlich 60% eines Edelgases (30% <= Edelgas <= 60%). Als Edelgas wird bevorzugt Argon verwendet.

Nochmals deutlich bessere Ergebnisse können erzielt werden mit einer Fluorgasmischung mit einem Anteil von 35% bis einschließlich 40% Fluor, einem Anteil von 1% bis 50% Stickstoff und einem Anteil von 30% bis einschließlich 59% eines Edelgases.

Die Fluor-Gasmischungen können auch aus F₂ / Edelgasen (He, Ar, Neon, Krypton, Xenon) / N₂ in Konzentrationen innerhalb der beanspruchten Grenzen bestehen, um nötige Selektivitäten und anisotrope Ätzanteile optimieren zu können.

Bisher waren Fluorgasmischungen dafür bekannt, dass diese eine sehr hohe Isotropie aufweisen, d.h. Fluorgasmischungen ätzen sehr ungerichtet. Daher eignen sich Fluorgasmischungen beispielsweise sehr gut als Reinigungsgas zum Reinigen von z.B. CVD-Kammern. Das Fluorgasgemisch flutet die CVD-Kammer und verteilt sich großflächig in der Kammer, um beispielsweise Rückstände an den Kammerwänden isotrop zu ätzen und dabei zu entfernen. Diese große Isotropie ist daher zum Reinigen durchaus erwünscht. Aufgrund dieser großen Isotropie sind Fluorgasmischungen dem allgemeinen Fachwissen nach jedoch nicht zum gerichteten Strukturieren von Substraten geeignet.

Im Unterschied zu CVD-Reinigungsplasmen, bei welchen F₂-Gasmischungen zur ganzflächigen Entfernung von z.B. Glasschichten oder amorphen Siliziumschichten an den CVD Reaktorwänden eingesetzt werden, handelt es sich bei der vorliegenden Erfindung jedoch um die erstmalige Verwendung von F₂-Gasmischungen zur Strukturerzeugung in Substraten (z.B. Silizium-Wafern) mit dem erklärten Ziel, das bis dato ausschließlich verwendete SF₆ Gas aus Umweltschutzgründen ersetzen zu können sowie gleichzeitig die Standzeiten der Ätzkammern respektive Vakuumkomponenten erhöhen zu können, da keine störenden Schwefelablagerungen entstehen können.

Der Ansatz, SF₆ beim DRIE-Ätzen von Fotomasken-strukturiertem Silizium durch umweltfreundliche F₂-Gasmischungen zu ersetzen, erfordert auch eine andere technische Herangehensweise im Vergleich zu CVD-Reinigungsvorgängen, bei denen Fluorgasmischungen einfach ungerichtet in die Kammer eingeleitet werden, um diese zu fluten. Ganz abgesehen davon unterscheiden sich die Zusammensetzungen bzw. prozentualen Verteilungen der einzelnen Gasbestandteile der bei CVD-Reinigungsprozessen verwendeten Fluorgasmischungen zu der Zusammensetzung der erfindungsgemäßen Fluorgasmischung. Hierbei ist zu erwähnen, dass bei Fluorgasmischungen bereits Abweichungen von 1% eines einzigen Gemischbestandteils dazu führen können, dass das gewünschte Verfahren nicht mehr durchführbar ist.

Da beim DRIE-Ätzen die nötige Selektivität zu Teflon-artigen Polymerschichten sowie eine Mindest-Anisotropie beim Durchbrechen derselben Schicht gezeigt werden muss, um die eigentliche Si-Ätzung durchführen zu können, ist die Zumischung von N₂ und Edelgasen (z.B. Argon als ein vergleichsweise schweres Atom) in das F₂-Gasgemisch ein neuer Lösungsansatz, um die nötige Sputter-Energie beim wiederholten Öffnen der zuvor polymerisierten Grabenböden erzielen zu können.

Die Verwendung von F₂-Gasgemischen anstelle 100% F₂ ist zum einen aus Sicherheitsgründen vorteilhaft, da 100% F₂ selbstentzündlich und hoch reaktiv ist. Darüber hinaus lässt sich mit 100% F₂ nicht die nötige Selektivität von Silizium zu üblichen Maskierungsschichten wie Photolack, Si-Gläsern oder Silizium-Nitrid erreichen, was ein weiterer Grund dafür ist, dass Fluorgasmischungen beim reaktiven lonenätzen bisher keine Verwendung gefunden haben.

Das erfindungsgemäße Verfahren kann entweder in einem konventionellen induktiv gekoppelten Plasma (z.B. bei 13,56 MHz) oder mit Hilfe eines Mikrowellenplasmas (z.B. bei 2,45 GHz) realisiert werden.

Die Verwendung der erfindungsgemäßen Fluorgasmischung in Kombination mit einem Mikrowellenplasma hat viele Vorteile.

Beispielsweise erzeugen Mikrowellenplasmen sehr hohe Radikaldichten bei vergleichsweise niederem Energieeinsatz, was insbesondere bei Verwendung von Fluorgasmischungen zu einer erheblich höheren Fluor-Radikaldichte im Vergleich zu einem mit niedrigerer Frequenz angeregten Plasma führt.

Da beim Einsatz von Mikrowellen zur F₂-Radikalbildung keine extra Matching Unit (elektromechanische Hochfrequenzanpassungseinheit) benötigt wird, ergibt sich für eine erfindungsgemäße Vorrichtung der Vorteil, dass diese im Vergleich zu den derzeit verwendeten Prozesskammern mit induktiv gekoppeltem Plasma (z.B. bei 13,56 MHz) betriebssicherer gebaut werden kann.

Das Polymerisierungsgas C₄F₈ kann zwar weiterhin verwendet werden. Jedoch ist das zum Passivieren verwendete C₄F₈ ebenso wie das im Stand der Technik zum Ätzen verwendete Ätzgas SF₆ sehr umweltschädlich. Daher ist es erfindungsgemäß vorgesehen, C₄F₈ oder SF₄ als mögliche Alternativen zu C₄F₈ und SF₆ zu verwenden. C₄F₆ hat lediglich einen GWP-Index von 1 (C₄F₆: GWP = 1) im Vergleich zu C₄F₈ (C₄F₈: GWP = 8700).

Nur Mikrowellen-Quellen neuester Bauart, welche durch Keramikoberflächen mit mehrfach nebeneinander angeordneten keramischen Hohlleitern eingekoppelt werden, erzeugen die nötige flächige und gleichverteilte Radikaldichte über die gesamte Waferfläche, um einen gleichmäßigen Si-Abtrag zu erreichen.

Der aufwendigere Ansatz, mehrere einzeln ansteuerbare Mikrowellenquellen in einer Matrixartigen, regelmäßig flächenverteilten Anordnung zusammenzufassen, erlaubt die weitere Optimierung der zu erzielenden Homogenität von Siliziumsubstraten im Durchmesserbereich 200mm bis 300mm. Die einzeln ansteuerbare Mikrowellenleistungsanpassung pro Einkoppel-Element erlaubt es, die über die Ätzkammer verteilte Ionenenergie und die über die Ätzkammer verteilte Radikaldichte sehr fein über die gesamte Reaktorfläche anzugleichen für einen möglichst homogenen Ätzabtrag.

Ein zweiter RF-Generator bei 13,56 MHz oder bei 400 kHz wird nur benötigt um eine regelbare und fein kontrollierbare lonenbeschleunigung (Sputterätzschritt) bei der Polymer-Öffnung in Richtung Kathode respektive Waferoberfläche erzeugen zu können. Die sehr leicht dissoziierbare erfindungsgemäße Fluorgasmischung benötigt relativ geringe RF-Leistungen, um eine zu SF₆ vergleichbare Fluor-Radikaldichte und damit auch eine hohe Si-Ätzrate erzeugen zu können.

Bei dem erfindungsgemäßen Verfahren ist es von Vorteil, wenn zum Aufbrechen der Passivierungsschicht bzw. Polymerisierungsschicht 103 Fluor-Ionen zur Verfügung stehen, wobei zum Strukturieren des Siliziumsubstrats 101 (nach dem Aufbrechen der Passivierungs- bzw. Polymerisierungsschicht 103) Fluor-Radikale erwünscht sind.

Ausführungsbeispiele der Erfindung sehen deshalb vor, dass das erfindungsgemäße Verfahren das Erzeugen von reaktiven Fluor-Ionen und Fluor-Radikalen beinhaltet, wobei in einem ersten Zeitabschnitt mehr reaktive Fluor-Ionen als Fluor-Radikale erzeugt werden, und wobei in einem nachfolgenden zweiten Zeitabschnitt mehr Fluor-Radikale als reaktive Fluor-Ionen erzeugt werden.

Die reaktiven Fluor-Ionen werden benötigt, um die Passivierungs- bzw. Polymerisierungsschicht 103 aufzubrechen. Die Fluor-Radikale wiederum ätzen mit hoher Selektivität das zu strukturierende Siliziumsubstrat 101. Daher sieht die Erfindung vor, zu Beginn eines Ätzschritts zuerst reaktive Fluor-Ionen zu erzeugen (z.B. für eine halbe Sekunde), die auf das Siliziumsubstrat 101 geleitet werden, um die im vorangegangenen Passivierungsschritt aufgebrachte Passivierungs- bzw. Polymerisierungsschicht 103 zu durchbrechen. Darauffolgend werden dann Fluor-Radikale erzeugt und auf das freigelegte Siliziumsubstrat 101 geleitet, um das Siliziumsubstrat 101 zu ätzen bzw. zu strukturieren.

Die Erzeugung von Radikalen und reaktiven Ionen in einem bestimmten Zeitfenster kann beispielsweise mittels einer mit der Plasmaquelle verbundenen Steuerung realisiert werden, die ausgebildet ist, um die Plasmaquelle entsprechend anzusteuern, sodass die Plasmaquelle zu unterschiedlichen Zeitpunkten unterschiedliche Verteilungen der Anteile an Fluor-Radikalen und Fluor-Ionen innerhalb des Plasmas produziert.

Beispielsweise kann die Steuerung ausgebildet sein, um die Anregungsfrequenz zum Erzeugen des Plasmas in Abhängigkeit von der Zeit zu erhöhen. Bei Hochfrequenzen unterhalb des Mikrowellenfrequenzbereichs, d.h. bei Frequenzen von etwa 30 MHz bis 300 MHz bilden sich sowohl Radikale als auch reaktive Ionen in dem Plasma aus. Bei einer Frequenz im Mikrowellenfrequenzbereich, d.h. bei Frequenzen von etwa 0,3 GHz bis 3 GHz, können die Ionen diesen hohen Frequenzen jedoch nicht mehr folgen und es bilden sich fast nur noch Radikale in dem Plasma aus.

Somit kann die Steuerung ausgebildet sein, um in dem ersten Zeitabschnitt das Plasma mit einer ersten Anregungsfrequenz zu erzeugen und in einem zweiten Zeitabschnitt das Plasma mit einer zweiten Anregungsfrequenz zu erzeugen, wobei die erste Anregungsfrequenz niedriger ist als die zweite Anregungsfrequenz, und wobei die erste Anregungsfrequenz vorzugsweise unterhalb des Mikrowellenfrequenzbereichs, d.h. bei etwa 30 MHz bis 300 MHz, und die zweite Anregungsfrequenz innerhalb des Mikrowellenfrequenzbereichs von 0,3 GHz bis 3 GHz liegt.

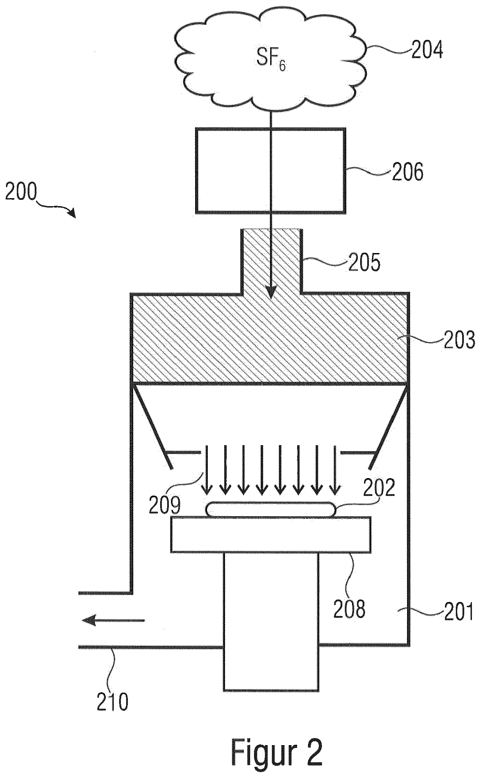

Figur 2 zeigt eine konventionelle Plasmaanlage 200 zum reaktiven Ionentiefenätzen gemäß dem Stand der Technik. Die Plasmaanlage 200 weist eine Prozesskammer 201 auf, in der sich ein zu strukturierendes Substrat 202 befindet. Die Plasmaanlage 200 weist außerdem eine Kammer mit einer Plasmaquelle 203 auf, in die SF₆ als Prozessgas 204 über einen Gaseinlass 205 eingeleitet werden kann. Das Prozessgas 204, hier SF₆, wird über einen vorgeschalteten Massendurchflussregler 206 zu der Plasmaquelle 203 geleitet.

Bisher verwendete Plasmaanlagen, wie sie in Figur 2 gezeigt sind, müssten für die Verwendung von erfindungsgemäßen Fluorgasmischungen entweder modifiziert werden um die höheren Sicherheitsanforderungen erfüllen zu können, oder es muss ein neuer Reaktor so konstruiert werden, dass die Verwendung erfindungsgemäßer Fluorgasmischungen sicherheitstechnisch problemlos möglich ist, da F₂-Gasmischungen toxisch und hoch korrosiv sind.

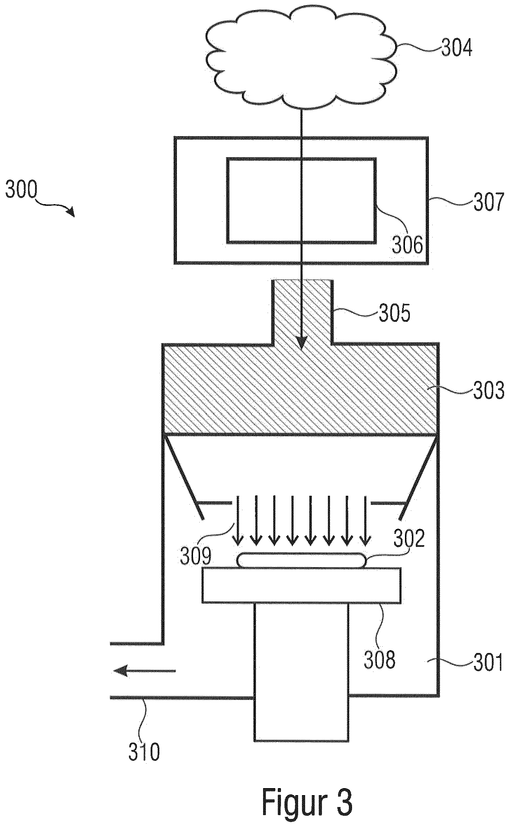

Stattdessen kann, wie in Figur 3 gezeigt, eine Plasmaanlage 300 bereitgestellt werden, die eine Absaugvorrichtung 307 für einen Massendurchflussregler 306 (engl. Mass Flow Controller, Abk. MFC) aufweist, wobei der Massendurchflussregler 306 die erfindungsgemäße Fluorgasmischung 304 in die Prozesskammer bzw. Vakuumkammer 301 transportiert.

Figur 3 zeigt eine beispielhafte Plasmaanlage 300 zum reaktiven Ionentiefenätzen. Die Plasmaanlage 300 weist eine Prozesskammer 301 auf, in der sich ein zu strukturierendes Substrat 302 befindet. Die Plasmaanlage 300 weist außerdem eine Kammer mit einer Plasmaquelle 303 auf. Im Vergleich zum Stand der Technik (Figur 2) wird in dieser beispielhaften Plasmaanlage 300 jedoch die beanspruchte Fluorgasmischung als Prozessgas 304 über einen Gaseinlass 305 eingeleitet. Die Fluorgasmischung wird über einen vorgeschalteten Massendurchflussregler 306 zu der Plasmaquelle 303 geleitet, wobei die zuvor erwähnte Absaugvorrichtung 307 zusätzlich vorgesehen ist.

Beiden Plasmaanlagen 200, 300 ist gemein, dass das zu strukturierende Substrat 202, 302 auf einer Elektrode 208, 308 angeordnet ist, zu der der Ionen- bzw. Gasstrom 209, 309 sehr gerichtet (hohe Anisotropie) verläuft. Außerdem weisen beide Plasmaanlagen 200, 300 einen Anschluss 210, 310 für eine Vakuumpumpe auf.

## Patentansprüche

1. Ätzverfahren mit den folgenden Schritten:
anisotropes Strukturieren eines Siliziumsubstrats (101, 302) mittels reaktivem Ionentiefenätzen (DRIE: deep reactive ion etching) mit mehreren abwechselnd aufeinander folgenden Ätzschritten und Passivierungsschritten,
wobei zum Ätzen eine Fluorgasmischung eingesetzt wird, die einen Anteil von mehr als 25% bis einschließlich 40% Fluor, einen Anteil von 1% bis 50% Stickstoff und einen Anteil von 30% bis einschließlich 60% eines Edelgases aufweist.

2. Ätzverfahren nach Anspruch 1, wobei die Fluorgasmischung einen Anteil von 35% bis einschließlich 40% Fluor, einen Anteil von 1% bis 50% Stickstoff und einen Anteil von 30% bis einschließlich 59% eines Edelgases aufweist.

3. Verfahren nach Anspruch 1 oder 2, wobei die Fluorgasmischung ein Edelgas aus der Gruppe von Argon, Neon, Krypton, Helium, Radon und Xenon aufweist.

4. Verfahren nach Anspruch 1 oder 2, wobei die Fluorgasmischung als Edelgaskomponente Argon aufweist.

5. Verfahren nach einem der vorhergehenden Ansprüche, wobei der Schritt des Passivierens das Aufbringen einer Passivierungsschicht auf das Siliziumsubstrat (101, 302) unter Verwendung von SF₄ oder C₄F₆ als Prozessgas beinhaltet.

6. Verfahren nach einem der vorhergehenden Ansprüche, wobei das Verfahren das Erzeugen von reaktiven Ionen in einem Hochfrequenz-Direktplasma beinhaltet, wobei bei dem Hochfrequenz-Direktplasma das Plasma mit einer Anregungsfrequenz von 3 MHz bis 300 GHz direkt in einer Ätzkammer erzeugt wird.

7. Verfahren nach Anspruch 6, wobei das Verfahren das Erzeugen von reaktiven Ionen in einem induktiv oder kapazitiv eingekoppelten Hochfrequenz-Direktplasma mit einer Anregungsfrequenz im Kurzwellen-Frequenzband in einem Frequenzbereich von 3 MHz bis 30 MHz, bevorzugt in einem Bereich von 13 MHz bis 15 MHz, und besonders bevorzugt in einem Bereich von 13,5 MHz bis 13,6 MHz beinhaltet.

8. Verfahren nach einem der Ansprüche 1 bis 6, wobei das Verfahren das Erzeugen von reaktiven Ionen in einem Hochfrequenz-Plasma mit einer Anregungsfrequenz im Mikrowellen-Frequenzband in einem Frequenzbereich von 0,3 GHz bis 3 GHz, bevorzugt in einem Frequenzbereich von 0,8 GHz bis 2,6 GHz, und besonders bevorzugt bei einer Frequenz von 2,45 GHz beinhaltet.

9. Verfahren nach einem der vorhergehenden Ansprüche, wobei das Verfahren das Erzeugen von reaktiven Ionen und Radikalen beinhaltet, wobei in einem ersten Zeitabschnitt mehr reaktive Ionen als Radikale erzeugt werden, und wobei in einem nachfolgenden zweiten Zeitabschnitt mehr Radikale als reaktive Ionen erzeugt werden.

10. Verwendung einer Fluorgasmischung zum anisotropen Strukturieren eines Siliziumsubstrats (101, 302) mittels reaktivem Ionentiefenätzen (DRIE: deep reactive ion etching) mit mehreren abwechselnd aufeinander folgenden Ätzschritten und Passivierungsschritten, wobei die Fluorgasmischung zum Ätzen eingesetzt wird und einen Anteil von mehr als 25% bis einschließlich 40% Fluor, einen Anteil von 1% bis 50% Stickstoff und einen Anteil von 30% bis einschließlich 60% eines Edelgases aus der Gruppe von Argon, Neon, Krypton, Helium, Radon und Xenon aufweist.

11. Verwendung einer Fluorgasmischung nach Anspruch 10, wobei die Fluorgasmischung einen Anteil von 35% bis einschließlich 40% Fluor, einen Anteil von 1% bis 50% Stickstoff und einen Anteil von 30% bis einschließlich 59% eines Edelgases aufweist.

## Claims

1. An etching method comprising:
anisotropically structuring a silicon substrate (101, 302) by means of deep reactive-ion etching (DRIE) with several alternating successive etching steps and passivation steps,
wherein a fluorine gas mixture is used for etching, comprising a proportion of more than 25% up to and including 40% of fluorine, a proportion of 1% to 50% of nitrogen and a proportion of 30% up to and including 60% of a noble gas.

2. The etching method according to claim 1, wherein the fluorine gas mixture comprises a proportion of 35% up to and including 40% of fluorine, a proportion of 1% to 50% of nitrogen and a proportion of 30% up to and including 59% of a noble gas.

3. The method according to claim 1 or 2, wherein the fluorine gas mixture comprises a noble gas from the group consisting of argon, neon, krypton, helium, radon and xenon.

4. The method according to claim 1 or 2, wherein the fluorine gas mixture comprises argon as the noble gas component.

5. The method according to any one of the preceding claims, wherein the step of passivating includes applying a passivation layer onto the substrate (101, 302) using SF₄ or C₄F₆ as the process gas.

6. The method according to any one of the preceding claims, wherein the method includes generating reactive ions in a high-frequency direct plasma, wherein, in the high-frequency direct plasma, the plasma is generated directly in an etching chamber with an excitation frequency of 3 MHz to 300 GHz.

7. The method according to claim 6, wherein the method includes generating reactive ions in an inductively or capacitively coupled high-frequency direct plasma with an excitation frequency in the shortwave frequency band in a frequency range of 3 MHz to 30 MHz, preferably in a range of 13 MHz to 15 MHz, and particularly preferably in a range of 13.5 MHz to 13.6 MHz.

8. The method according to any one of claims 1 to 6, wherein the method includes generating reactive ions in a high-frequency plasma with an excitation frequency in the microwave frequency band in a frequency range of 0.3 GHz to 3 GHz, preferably in a frequency range of 0.8 GHz to 2.6 GHz, and particularly preferably at a frequency of 2.45 GHz.

9. The method according to any one of the preceding claims, wherein the method includes generating reactive ions and radicals, wherein more reactive ions are generated in a first time period than radicals, and wherein more radicals are generated in a subsequent second time period than reactive ions.

10. A use of a fluorine gas mixture for anisotropically structuring a silicon substrate (101, 302) by means of deep reactive-ion etching (DRIE) with several alternating successive etching steps and passivation steps, wherein the fluorine gas mixture is used for etching and comprises a proportion of more than 25% up to and including 40% of fluorine, a proportion of 1% up to 50% of nitrogen and a proportion of 30% up to and including 60% of a noble gas from the group consisting of argon, neon, krypton, helium, radon and xenon.

11. The use of a fluorine gas mixture according to claim 10, wherein the fluorine gas mixture comprises a proportion of 35% up to and including 40% of fluorine, a proportion of 1% to 50% of nitrogen and a proportion of 30% up to and including 59% of a noble gas.

## Revendications

1. Procédé de gravure aux étapes suivantes consistant à:
structurer de manière anisotrope un substrat de silicium (101, 302) au moyen d'une gravure profonde par ions réactifs (DRIE: deep reactive ion etching) avec plusieurs étapes de gravure et étapes de passivation successives en alternance,
dans lequel est utilisé pour la gravure un mélange de fluor gazeux qui présente une part de plus de 25% à 40% inclus de fluor, une part de 1% à 50% d'azote et une part de 30% à 60% inclus d'un gaz noble.

2. Procédé de gravure selon la revendication 1, dans lequel le mélange de fluor gazeux présente une part de 35% à 40% inclus de fluor, une part de 1% à 50% d'azote et une part de 30% à 59% inclus d'un gaz noble.

3. Procédé selon la revendication 1 ou 2, dans lequel le mélange de fluor gazeux présente un gaz noble choisi parmi le groupe constitué d'argon, de néon, de krypton, d'hélium, de radon et de xénon.

4. Procédé selon la revendication 1 ou 2, dans lequel le mélange de fluor gazeux présente de l'argon comme composant de gaz noble.

5. Procédé selon l'une des revendications précédentes, dans lequel l'étape de passivation comporte le fait d'appliquer une couche de passivation sur le substrat de silicium (101, 302) à l'aide de SF₄ ou de C₄F₆ comme gaz de processus.

6. Procédé selon l'une des revendications précédentes, dans lequel le procédé comporte le fait de générer des ions réactifs dans un plasma direct haute fréquence, dans lequel, dans le cas de plasma direct de haute fréquence, le plasma est généré directement dans une chambre de gravure à une fréquence d'excitation de 3 MHz à 300 GHz.

7. Procédé selon la revendication 6, dans lequel le procédé comporte le fait de générer des ions réactifs dans un plasma direct de haute fréquence couplé de manière inductive ou capacitive à une fréquence d'excitation dans la bande de fréquences des ondes courtes dans une plage de fréquences de 3 MHz à 30 MHz, de préférence dans une plage de 13 MHz à 15 MHz MHz, et de manière particulièrement préférée dans une plage de 13,5 MHz à 13,6 MHz.

8. Procédé selon l'une des revendications 1 à 6, dans lequel le procédé comporte le fait de générer des ions réactifs dans un plasma de haute fréquence à une fréquence d'excitation dans la bande de fréquences des micro-ondes dans une plage de fréquences de 0,3 GHz à 3 GHz, de préférence dans une plage de fréquences de 0,8 GHz à 2,6 GHz, et de manière particulièrement préférée à une fréquence de 2,45 GHz.

9. Procédé selon l'une des revendications précédentes, dans lequel le procédé comporte le fait de générer des ions réactifs et des radicaux, dans lequel sont générés, dans une première période de temps, plus d'ions réactifs que de radicaux, et dans lequel sont générés, dans une deuxième période de temps successive, plus de radicaux que d'ions réactifs.

10. Utilisation d'un mélange de fluor gazeux pour structurer de manière anisotrope un substrat de silicium (101, 302) au moyen d'une gravure profonde par ions réactifs (DRIE: deep reactive ion etching) avec plusieurs étapes de gravure et étapes de passivation successives en alternance, dans laquelle le mélange de fluor gazeux est utilisé pour la gravure et présente une part de plus de 25% à 40% inclus de fluor, une part de 1% à 50% d'azote et une part de 30% à 60% inclus d'un gaz noble choisi parmi le groupe constitué d'argon, de néon, de krypton, d'hélium, de radon et de xénon.

11. Utilisation d'un mélange de fluor gazeux selon la revendication 10, dans laquelle le mélange de fluor gazeux présente une part de 35% à 40% inclus de fluor, une part de 1% à 50% d'azote et une part de 30% à 59% inclus d'un gaz noble.
